# EUROPEAN PATENT APPLICATION

(11) **EP 4 791 151 A1**
(43) Date of publication of application: **12.08.2026**
(21) Application number: 25211946.6
(22) Date of filing: 29.10.2025
(51) Int. Cl.: H10F 39/00

(54) **IMAGE SENSING DEVICE**

(30) Priority: 07.02.2025 KR 20250015762
(71) Applicant: SK hynix Inc., Bubal-eub Icheon-si Gyeonggi-do 17336 (KR)
(72) Inventor: KWAG, Pyong Su, 17336 Icheon-si, Gyeonggi-do (KR)
(74) Representative: Isarpatent

(57) **Abstract**

An image sensing device includes a substrate including a first surface and a second surface opposite to the first surface; a first well region including impurities of a first conductivity type and disposed in the substrate to be in contact with the second surface; a second well region including impurities of a second conductivity type opposite to the first conductivity type and disposed in the substrate to be in contact with the first well region; a first interconnect electrically connected to the first well region through a first contact plug; a second interconnect electrically connected to the second well region through a second contact plug; and a field-dispersion electrode connected to a third interconnect through a third contact plug and disposed to cover an edge region of the second well region between the first contact plug and the second contact plug.

## Description

### CROSS-REFERENCE TO RELATED APPLICATION

This patent document claims the priority and benefits of Korean patent application No. 10-2025-0015762, filed on February 07, 2025, which is incorporated by reference in its entirety as part of the disclosure of this patent document.

### TECHNICAL FIELD

The technology and implementations disclosed in this patent document generally relate to an image sensing device including a single-photon avalanche diode (SPAD).

### BACKGROUND

Time of Flight (TOF) technology, which has gained significant attention recently, measures the distance to a target object by emitting pulse-shaped light from a light source located near a sensor, capturing light reflected from the target object, calculating a round trip time using emitted light and reflected light, and producing the distance to the target object using the calculated round trip time.

For precise TOF measurements, the reflected light must be detected immediately after reaching the sensor. This requires highly sensitive photoelectric conversion elements.

To this end, active research has been conducted on single-photon avalanche diodes (SPADs) that can be fabricated using CMOS fabrication technology. Single-photon avalanche diodes (SPADs) are optical devices with very high gain characteristics. Single-photon avalanche diode (SPAD) can amplify emitted photons for detection using the avalanche multiplication effect in the diode, which occurs when a reverse bias voltage exceeding an avalanche breakdown threshold voltage is applied. As a result, single-photon avalanche diodes (SPADs) exhibit sufficiently high photoelectric conversion efficiency to detect even a single photon.

### SUMMARY

Various embodiments of the disclosed technology relate to an image sensing device designed to improve the sensitivity of a pixel by changing a position where avalanche breakdown will occur to another position.

In an embodiment of the disclosed technology, an image sensing device may include a substrate including a first surface and a second surface opposite to the first surface; a first well region including impurities of a first conductivity type and disposed in the substrate to be in contact with the second surface; a second well region including impurities of a second conductivity type opposite to the first conductivity type and disposed in the substrate to be in contact with the first well region; a plurality of interconnects configured to provide electrical connections within the image sensing device; a plurality of contact plugs configured to provide electrical connections to the plurality of interconnects, wherein the plurality of interconnects includes first, second, and third interconnects, and the plurality of contact plugs includes first, second, and third contact plugs, wherein the first interconnect is electrically connected to the first well region through the first contact plug, and the second interconnect is electrically connected to the second well region through the second contact plug; and a field-dispersion electrode connected to the third interconnect through the third contact plug and disposed to cover an edge region of the second well region between the first contact plug and the second contact plug.

In another embodiment of the disclosed technology, an image sensing device may include a substrate including a first well region having impurities of a first conductivity type and a second well region having impurities of a second conductivity type opposite to the first conductivity type, and configured to contact the first well region; a field-dispersion electrode configured to cover an edge region of the second well region and disposed over the substrate to be spaced apart from the substrate by a first height; a first interconnect disposed over the substrate at a second height greater than the first height and connected to the first well region; a second interconnect disposed over the substrate to be spaced apart from the substrate by the second height and connected to the second well region; and a third interconnect disposed over the substrate to be spaced apart from the substrate by the second height and connected to the field-dispersion electrode.

It is to be understood that both the foregoing general description and the following detailed description of the disclosed technology are illustrative and explanatory and are intended to provide further explanation of the disclosure as claimed.

### BRIEF DESCRIPTION OF THE DRAWINGS

The above and other features and beneficial aspects of the disclosed technology will become readily apparent with reference to the following detailed description when considered in conjunction with the accompanying drawings.
FIG. 1 is a block diagram illustrating an example of an imaging device based on an embodiment of the disclosed technology.
FIG. 2 is a plan view illustrating an example of a planar structure of pixels included in a pixel array shown in FIG. 1 based on an embodiment of the disclosed technology.
FIG. 3 is a plan view illustrating an example of a planar structure of conductive lines formed over the structure shown in FIG. 2 based on an embodiment of the disclosed technology.
FIG. 4 is a cross-sectional view illustrating a cross-section of the structure taken along the line X-X' shown in FIG. 3 based on an embodiment of the disclosed technology.
FIG. 5A is a diagram illustrating an example of electric field concentration occurring at an edge region of a P-N junction under reverse bias when a field-dispersion electrode is not formed, based on an embodiment of the disclosed technology.
FIG. 5B is a diagram illustrating an example of how the electric field is distributed in an edge region of a P-N junction by a field-dispersion electrode based on an embodiment of the disclosed technology.
FIG. 6A is a diagram illustrating an example structure of metal interconnects based on another embodiment of the disclosed technology.
FIG. 6B is a diagram illustrating an example structure of metal interconnects based on another embodiment of the disclosed technology.
FIG. 7 is a cross-sectional view illustrating an example structure of an imaging device based on another embodiment of the disclosed technology.
FIG. 8 is a cross-sectional view illustrating an example structure of an image sensing device based on another embodiment of the disclosed technology.
FIG. 9 is a cross-sectional view illustrating an example structure of an image sensing device based on another embodiment of the disclosed technology.
FIG. 10 is a cross-sectional view illustrating an example structure of an image sensing device based on another embodiment of the disclosed technology.

### DETAILED DESCRIPTION

This patent document provides implementations and examples of an image sensing device including a single-photon avalanche diode (SPAD) that may be used to substantially address one or more technical or engineering issues and mitigate limitations or disadvantages encountered in some other image sensing devices. The disclosed technology can be implemented in some embodiments to provide an image sensing device that can improve the sensitivity of a pixel by shifting the location where avalanche breakdown will occur. The disclosed technology can be implemented in some embodiments to provide an image sensing device that can enable the avalanche breakdown to occur in a wider and more uniform region, thereby improving the pixel sensitivity.

The following description refers in detail to certain embodiments, examples of which are illustrated in the accompanying drawings. Wherever possible, like reference numerals and characters are used throughout the accompanying drawings to refer to like components. In the following description, a detailed description of related known configurations or functions will be omitted to avoid obscuring the subject matter.

Hereinafter, various embodiments will be described with reference to the accompanying drawings. However, it should be understood that the disclosed technology is not limited to specific embodiments, but encompasses various modifications, equivalents and alternatives of the embodiments. The embodiments of the disclosed technology may provide a variety of effects capable of being directly or indirectly recognized through the disclosed technology.

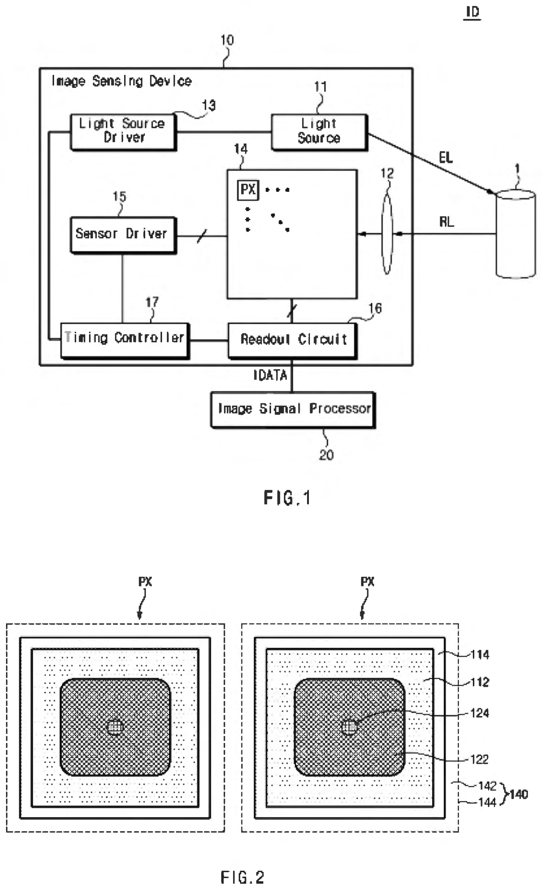

FIG. 1 is a block diagram illustrating an example of an imaging device (ID) including an image sensing device 10 based on an embodiment of the disclosed technology.

Referring to FIG. 1, the imaging device (ID) may refer to a device, for example, a digital still camera for photographing still images or a digital video camera for photographing moving images. For example, the imaging device (ID) may be implemented as a Digital Single Lens Reflex (DSLR) camera, a mirrorless camera, or a smartphone, and others. The imaging device (ID) may include a device having an image pickup element to capture (or photograph) a target object and creating an image of the target object. In some implementations, the imaging device (ID) may be implemented as a Lidar sensor.

The imaging device (ID) may include an image sensing device 10 and an image signal processor (ISP) 20.

The image sensing device 10 may be a complementary metal oxide semiconductor image sensor (CIS) for converting incident light into electrical signals. The image sensing device 10 may include a light source 11, a lens module 12, a light source driver 13, a pixel array 14, a sensor driver 15, a readout circuit 16, and a timing controller 17.

The light source 11 may emit light to a target object 1 upon receiving a control signal from the light source driver 13. For example, the light source 11 may emit light (e.g., near infrared (NIR) light, infrared (IR) light or visible light) having a specific wavelength band. Although FIG. 1 shows only one light source 11 for convenience of description, the scope or spirit of the disclosed technology is not limited thereto, and a plurality of light sources may also be arranged in the vicinity of the lens module 12.

The lens module 12 may collect light reflected from the target object 1, and may allow the collected light to be focused onto pixels (PXs) of the pixel array 14.

The light source driver 13 may drive the light source 11 under control of the timing controller 17. In particular, the light source driver 13 may control waveforms (e.g., a period, amplitude, pulse width, etc.) of emitted light (EL) output from the light source 11.

The pixel array 14 may include a plurality of unit pixels (PXs) consecutively arranged in a two-dimensional (2D) matrix structure (e.g., consecutively arranged in a column direction and a row direction). The plurality of unit pixels (PXs) may be formed in a semiconductor substrate, and each unit pixel (PX) may convert incident light received through the lens module 12 into an electric signal corresponding to the intensity of the incident light to generate a pixel signal.

Each unit pixel (PX) may generate a pixel signal by sensing incident light that includes reached light (RL) generated when emitted light (EL) from the light source 11 is reflected from the target object 1. Although the present embodiment assumes that the reached light (RL) is light obtained when emitted light (EL) from the image sensing device 10 is reflected from the target object 1 and incident upon the pixel array 14 for convenience of description, the scope or spirit of the disclosed technology is not limited thereto. For example, the light source 11 may be provided in a separate device other than the image sensing device 10, and the reached light (RL) may be obtained when the emitted light (EL) from the light source 11 is directly incident upon the pixel array 14. In some implementations, the unit pixel (PX) may be a pixel for calculating the distance to the target object 1. According to another embodiment, the unit pixel (PX) may include a pixel for generating an infrared image by sensing infrared light incident from a scene without sensing reflected light, or may include a pixel for generating a color image by sensing visible light incident from a scene.

In some embodiments, each unit pixel (PX) may include a single-photon avalanche diode (SPAD) as a photoelectric conversion element.

For reference, the single-photon avalanche diode (SPAD) may be used as a photoelectric conversion element including a photosensitive P-N junction. The single-photon avalanche diode (SPAD) may detect a photon reflected by a target object and generate a current pulse corresponding to the detected photon. In this case, in a state in which a reverse bias voltage higher than a breakdown voltage is applied to a cathode and anode (cathode-anode) of the single-photon avalanche diode (SPAD), avalanche breakdown may be triggered by incident photon so that a current pulse can be generated. Here, avalanche breakdown may occur in a depletion region in the single-photon avalanche diode (SPAD).

The sensor driver 15 may drive the pixels (PXs) of the pixel array 14 in response to a timing signal output from the timing controller 17. For example, the sensor driver 15 may generate a control signal capable of selecting and controlling unit pixels (PXs) included in at least one row line from among a plurality of row lines of the pixel array 14.

The readout circuit 16 may process pixel signals received from the pixel array 14 under control of the timing controller 17, and may generate and store depth data for detecting the distance to the target object 1.

The timing controller 17 may generate a timing signal to control the light source driver 13, the sensor driver 15, and the readout circuit 16. In some implementations, the timing controller 17 may generate a timing signal according to a prestored sequence, data received from the readout circuit 16 and/or a request received from the image signal processor 20. In some implementations, the timing controller 17 may include a logic control circuit, a phase-locked loop (PLL) circuit, a timing control circuit, a communication interface circuit and others.

The image signal processor 20 may perform at least one image signal process on image data (IDATA) received from the image sensing device 10, and may thus generate the processed image data. For example, the image signal processor 20 may reduce noise of image data (IDATA), and may perform various kinds of image signal processing (e.g., interpolation of image data (IDATA), lens distortion correction, etc.) for image-quality improvement of the image data. In addition, the image signal processor 20 may transmit a control signal for controlling operations (whether or not to operate, an operation timing, an operation mode, etc.) of the image sensing device 10 to the image sensing device 10.

In a photodiode that includes impurity regions and junction regions between different impurity regions, applying different voltages to the electrodes of the photodiode creates a voltage difference, and the highest electric field can occur at the junction edges. This localized high electric field can cause breakdown at the edges, restricting the breakdown region and adversely affecting sensitivity.

To address this issue, the disclosed technology can be implemented in some embodiments to provide an electrode disposed above the junction edges of the photodiode to disperse the high electric field at the junction edge, providing a broader and more uniform breakdown area.

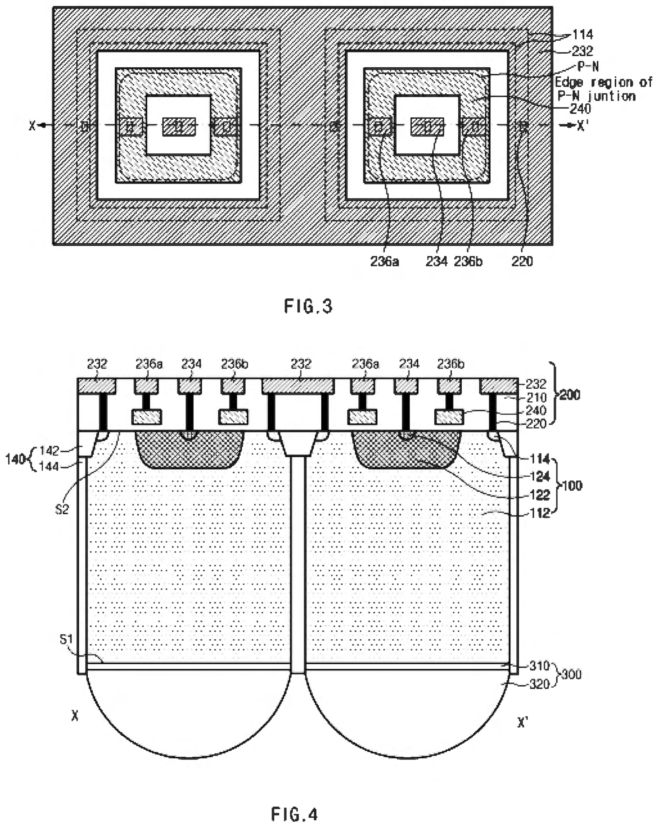

FIG. 2 is a plan view illustrating an example of a planar structure of pixels included in the pixel array shown in FIG. 1 based on an embodiment of the disclosed technology. FIG. 3 is a plan view illustrating an example of a planar structure of conductive lines formed over the structure shown in FIG. 2 based on an embodiment of the disclosed technology. FIG. 4 is a cross-sectional view illustrating a cross-section of the structure taken along the line X-X' shown in FIG. 3 based on an embodiment of the disclosed technology.

FIG. 2 illustrates an example view in which the substrate 100 is viewed from a second surface (S2) opposite to the first surface (S1) upon which light is incident. From the perspective inside the substrate, the first surface (S1) faces the second surface (S2).

Referring to FIGS. 2 to 4, the pixel array 14 may include a substrate 100 upon which unit pixels (PXs) are formed, an interconnect layer 200 formed on a second surface (S2) of the substrate 100, and a light incident layer 300 formed on a first surface (S1) of the substrate 100. Each unit pixel (PX) may include a first well region 112, a first contact region 114, a second well region 122, and a second contact region 124 formed within the substrate 100.

The substrate 100 may include the first surface (S1) and the second surface (S2) facing away from each other. In this case, the first surface (S1) may be a surface in contact with the light incident layer 300, and the second surface (S2) may be a surface in contact with the interconnect layer 200. The substrate 100 may include, for example, a monocrystalline silicon substrate. For example, the substrate 100 may be, for example, a P-type or N-type bulk substrate, may be, for example, a substrate formed by growing a P-type or N-type epitaxial layer on the P-type bulk substrate, or may be, for example, a substrate formed by growing a P-type or N-type epitaxial layer on the N-type bulk substrate. For convenience, an example case in which the substrate 100 is a P-type bulk substrate will be described.

The first well region 112 may include impurities of a first conductivity type (e.g., P-type), and may be located within the substrate 100. For example, the P-type substrate may be the first well region 112. The first well region 112 may be located within the substrate 100 in a shape in which the first well region 112 surrounds the second well region 122 so as to entirely contact the side and bottom surfaces of the second well region 122.

The first contact region 114 may include impurities of the first conductivity type (P⁺) at a high concentration, and may be located within the first well region 112 so as to extend from the second surface (S2) of the substrate 100 by a predetermined depth. The first contact region 114 may be formed by implanting the first- conductivity-type impurities having high concentration into the first well region 112. This first contact region 114 may be an anode of the single-photon avalanche diode (SPAD), and may be a sensing node from which a current pulse detected by the SPAD is output.

The first contact region 114 may be located at an edge region of the unit pixel (PX). In a top view, the first contact region 114 may be formed in a band shape surrounding the second well region 122 as shown in FIG. 2.

The second well region 122 may include impurities of a second conductivity type (e.g., N-type) opposite to the first conductivity type. The second well region 122 may be disposed to extend from the second surface (S2) of the substrate 100 by a predetermined depth in the depth direction so that both the side surface and the bottom surface of the second well region 122 are in contact with the first well region 112. For example, the second well region 122 may be formed by implanting second- conductivity-type impurities into the first well region 112.

In a vertical cross-section, the second well region 122 may be formed such that a diameter of the bottom surface of the second well region 122 is larger than a height (depth) of the side surface of the second well region 122, as shown in FIG. 4. As shown in FIG. 2, in plan view, the second well region 122 may be located at a central portion of the unit pixel (PX) such that the second well region 122 is surrounded by the first well region 112.

A region in which the second well region 122 and the first well region 112 are in contact with each other may serve as a P-N junction of the SPAD where avalanche breakdown may occur. Although FIG. 2 illustrates an example case in which the second well region 122 is formed in a square shape in plan view, the second well region 122 may also be formed in a circular shape.

The second contact region 124 may include high-concentration second- conductivity-type impurities, and may be disposed within the second well region 122, extending to a predetermined depth from the second surface (S2) of the substrate 100. The second contact region 124 may be formed by implanting high-concentration second-conductivity-type impurities into the second well region 122. As shown in FIG. 2, the second contact region 124 may be located at the center of the second well region 122 in plan view.

The second contact region 124 may be a cathode of the SPAD, and may be a biasing node to which a high reverse bias voltage is applied to cause avalanche breakdown in the SPAD. Therefore, the SPAD based on an embodiment may be a cathode-biased SPAD in which a reverse bias voltage is applied to the N-type impurity region (e.g., cathode).

A pixel isolation structure 140 may be formed between adjacent unit pixels (PX) within the substrate 100. The pixel isolation structure 140 may serve to prevent optical crosstalk between adjacent unit pixels (PXs). The pixel isolation structure 140 may include a trench isolation structure in which an insulation material is embedded in a trench formed by etching the substrate 100, and may be formed to penetrate the substrate 100.

The pixel isolation structure 140 may include a first isolation structure 142 and a second isolation structure 144. The first isolation structure 142 may include a shallow trench isolation (STI) structure that extends to a predetermined depth from the second surface (S2) of the substrate 100. The second isolation structure 144 may include a deep trench isolation (DTI) structure that is connected to the bottom surface of the first isolation structure 142 and formed to penetrate the substrate 100. The second isolation structure 144 may include a structure in which conductive material (e.g., metal) is embedded in an insulation layer. In addition, the second isolation structure 144 may be formed to protrude from the first surface (S1) of the substrate 100, and may extend between adjacent microlenses 320.

The interconnect layer 200 may be formed over the second surface (S2) of the substrate 100. The interconnect layer 200 may be disposed to be in contact with the second surface (S2) of the substrate 100. The interconnect layer 200 may include an interlayer insulation layer 210, contact plugs 220, metal interconnects (232, 234, 236a, 236b), and an electric field-dispersion electrode (hereinafter referred to as a field-dispersion electrode) 240.

The interlayer insulation layer 210 may include at least one of an oxide layer and a nitride layer, and may electrically isolate the contact plugs 220, the metal interconnects (232, 234, 236a, 236b), and the field-dispersion electrode 240 from each other within the interconnect layer 200. The contact plugs 220 may electrically connect the metal interconnects (232, 234, 236a, 236b) to respective ones of the first contact region 114, the second contact region 124, and the field-dispersion electrode 240.

The metal interconnects (232, 234, 236a, 236b) may be disposed on the same layer within the interlayer insulation layer 210, and may include a plurality of interconnects through which a voltage required to control the SPAD and a current pulse detected by the SPAD can be transmitted. The metal interconnects (232, 234, 236a, 236b) may be the lowest metal interconnect from among the plurality of metal interconnects required to transmit signals within the interconnect layer 200.

The metal interconnect 232 may be connected to a sensing node of the SPAD formed in each unit pixel (PX). The metal interconnect 232 may be commonly connected to the first contact regions 114 of the unit pixels (PX) through the contact plugs 220. The metal interconnect 232 may be formed to cover the edge region of the first well region 112 such that the metal interconnect 232 vertically overlaps the first contact region 114 in the region of each unit pixel (PX) while exposing the field-dispersion electrode 240. In addition, the metal interconnect 232 may be formed to extend to a boundary region of the adjacent unit pixels (PXs) such that the metal interconnects 232 of the adjacent unit pixels (PXs) are formed as a single continuous structure. For example, the metal interconnects 232 may be formed as a single metal interconnect that is integrally formed over the entire pixel array 14.

The metal interconnects 234 may be metal interconnects connected to the biasing node of the SPAD formed in each unit pixel (PX). The metal interconnects 234 may be disposed to overlap the second contact region 124 of each unit pixel (PX), and may be connected to the second contact region 124 through the contact plug 220. The metal interconnects (236a, 236b) may be disposed to overlap the field-dispersion electrode 240, and may be connected to the field-dispersion electrode 240 through the contact plug 220.

The field-dispersion electrode 240 may be disposed adjacent to the substrate 100 between the substrate 100 and the metal interconnects (236a, 236b), and may be disposed to cover the entire edge region of the second well region 122. The field-dispersion electrode 240 may be disposed between the contact plugs 220 of the metal interconnects (232, 234) within the interlayer insulation layer 210.

The field-dispersion electrode 240 may be formed in a band shape that exposes the central portion of the second well region 122 while covering the entire edge region of the second well region 122. For example, as shown in FIG. 3, the field-dispersion electrode 240 may be formed in a rectangular band shape. Although FIG. 3 illustrates only the example case in which the field-dispersion electrode 240 is formed in a rectangular band shape, the field-dispersion electrode 240 may have any shape as long as it can expose the central portion of the second well region 122 and can entirely cover the edge region of the second well region 122. Alternatively, the field-dispersion electrode 240 may be formed in an open-curve shape with partial openings, rather than a fully closed loop shape.

The field-dispersion electrode 240 may be formed to entirely or partially cover the edge region of the second well region 122 while entirely or partially covering the edge region of the region (i.e., P-N junction) in which the first well region 112 and the second well region 122 are in contact with each other. The edge region of the P-N junction may refer to a region adjacent to the second surface (S2) of the substrate 100 within the P-N junction. Hereinafter, an example case in which the field-dispersion electrode 240 entirely covers the edge region of the second well region 122 and the edge region of the P-N junction will be described by way of example.

A voltage having a magnitude between the voltage magnitudes applied to the first contact region 114 and the second contact region 124 may be applied to the field-dispersion electrode 240. In some implementations, the magnitude of the voltage applied to the field-dispersion electrode 240 may be determined based on the impurity concentrations of the first well region 112 and the second well region 122.

In addition, the field-dispersion electrode 240 may be located as close to the substrate 100 as possible within a range where a potential difference (e.g., electrical potential difference or voltage difference) between the substrate 100 and the field-dispersion electrode 240 does not become higher than an energy barrier of the interlayer insulation layer 210 disposed between the substrate 100 and the field-dispersion electrode 240.

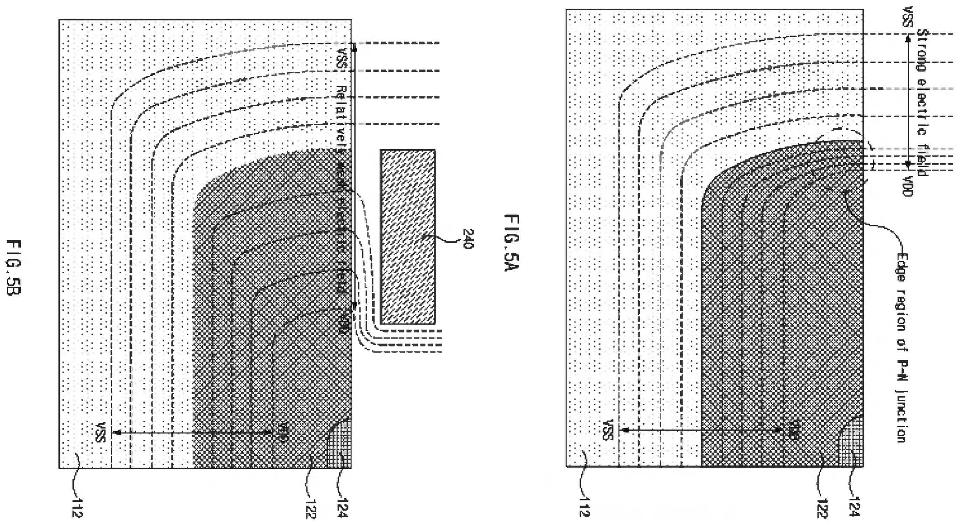

The field-dispersion electrode 240 may increase a potential between the edge region of the P-N junction and the edge region (e.g., the region adjacent to the edge region of the P-N junction) of the second well region 122 to prevent the electric field from being concentrated in the edge region of the P-N junction. As a result, the field-dispersion electrode 240 may allow avalanche breakdown to occur not in the edge region of the P-N junction but in the lower region of the P-N junction. The lower region of the P-N junction may refer to a region where the P-N junction contacts the bottom surface of the first well region 122. The functions and effects of the field-dispersion electrode 240 will be described later with reference to FIG. 5.

A light incident layer 300 may be formed over the first surface (S1) of the substrate 100 to focus incident light reflected from the target object 1 onto the unit pixels (PXs). For example, the light incident layer 300 may be disposed to contact the first surface (S1) of the substrate 100. The light incident layer 300 may include an anti-reflection layer 310 and a microlens 320.

The anti-reflection layer 310 may be formed over the first surface (S1) of the substrate 100 to prevent irregular or diffuse reflection of incident light and protect the substrate 100. The microlens 320 may be formed in a hemispherical shape over the anti-reflection layer 310, and may increase light reception (Rx) efficiency by increasing light gathering power of incident light.

Although only an example case is described in which the light incident layer 300 includes the microlens 320 for convenience of description, other implementations are also possible, and other types of lens layers may also be formed as needed. For example, a metalens may be formed instead of the microlens 320.

Although the above-described embodiment illustrates the example case where each of the first well region 112 and the first contact region 114 includes P-type impurities and each of the second well region 122 and the second contact region 124 includes N-type impurities, other implementations are also possible. Alternatively, the first well region 112 and the first contact region 114 may include N-type impurities and the second well region 122 and the second contact region 124 may include P-type impurities. In such a case, the first contact region 114 may be a cathode, and may be used as a sensing node. The second contact region 124 may be an anode, and may be used as a biasing node. Therefore, in another embodiment, the SPAD may be an anode-biased SPAD in which a low reverse bias voltage is applied to the P-type impurity region (e.g., anode).

In addition, although the above-described embodiment illustrates that the contact plugs 220 are connected to the first well region 112 or the second well region 122 through the first contact region 114 or the second contact region 124, other implementations are also possible. For example, the contact plugs 220 may also be directly connected to the first well region 112 or the second well region 122.

FIG. 5A is a diagram illustrating an example of electric field concentration occurring at the edge region of a P-N junction under reverse bias when a field-dispersion electrode is not formed based on an embodiment of the disclosed technology. FIG. 5B is a diagram illustrating an example of how the electric field is distributed in the edge region of a P-N junction by a field-dispersion electrode based on an embodiment of the disclosed technology.

In FIGS. 5A and 5B, each of the arrows represents the intensity of the electric field at the P-N junction. A shorter arrow indicates a stronger electric field intensity.

When a reverse bias voltage higher than the breakdown voltage is applied to the anode and cathode of the SPAD so that avalanche breakdown occurs in the SPAD, the electric field may be concentrated in the edge region of the P-N junction as shown in FIG. 5A. As a result, a potential difference between the first well region 112 and the second well region 122 in the edge region of the P-N junction may become higher than a potential difference between the first well region 112 and the second well region 122 in the lower region of the P-N junction.

The avalanche breakdown may occur in a region with a high potential difference. Accordingly, in the structure shown in FIG. 5A, the avalanche breakdown primarily occurs in a narrow edge region, which may deteriorate the sensitivity of the SPAD.

On the other hand, when the field-dispersion electrode 240 is located adjacent to the edge region of the second well region 122 and increases the potential of the corresponding region, the electric field in the corresponding region can be dispersed as shown in FIG. 5B. As a result, the potential difference between the first well region 112 and the second well region 122 in the edge region of the P-N junction may become lower than the potential difference between the first well region 112 and the second well region 122 in the lower region of the P-N junction.

In this way, if the potential in the lower region of the P-N junction where the potential difference is uniformly generated in a wide region becomes relatively higher than the potential difference in the edge region, avalanche breakdown may occur in the lower region of the P-N junction. That is, the field-dispersion electrode 240 may shift the location of the avalanche breakdown to a large region with a more uniform potential difference. As a result, the sensitivity of the SPAD can be improved.

The critical dimension (CD) (e.g., the length extending from the P-N junction toward the second contact region 124) of the field-dispersion electrode 240, the magnitude of a voltage to be applied to the field-dispersion electrode 240, and the distance between the field-dispersion electrode 240 and the substrate 100 may be determined based on the concentrations of the first well region 112 and the second well region 122, and the material properties of the interlayer insulation layer 210.

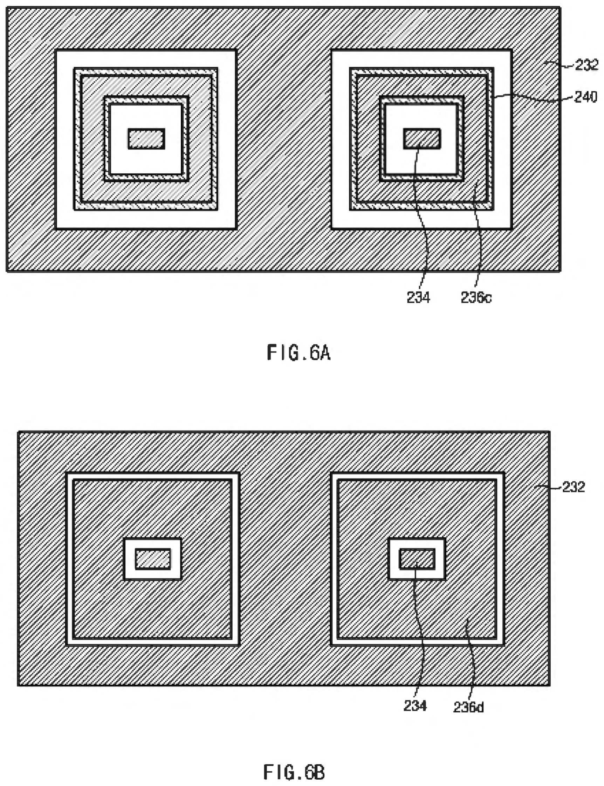

FIG. 6A is a diagram illustrating an example structure of metal interconnects based on another embodiment of the disclosed technology. FIG. 6B is a diagram illustrating an example structure of metal interconnects based on another embodiment of the disclosed technology.

The metal interconnects of FIGS. 6A and 6B have a difference in the metal interconnects (236c, 236d) connected to the field-dispersion electrode 240 as compared to the metal interconnects of FIG. 3 described above.

In FIG. 3, the metal interconnects (236a, 236b) connected to the field-dispersion electrode 240 are formed in island shapes that are separated from each other, but each of the metal interconnect 236c of FIG. 6A and the metal interconnect 236d of FIG. 6B may be formed in a rectangular band shape like the field-dispersion electrode 240. For example, FIG. 6A illustrates an example case where the critical dimension (CD) of the metal interconnect 236c is formed smaller than the critical dimension (CD) of the field-dispersion electrode 240, and FIG. 6B illustrates an example case where the critical dimension (CD) of the metal interconnect 236d is formed larger than the critical dimension (CD) of the field-dispersion electrode 240 to cover the entire field-dispersion electrode 240.

As shown in FIGS. 6A and 6B, each of the metal interconnects (236c, 236d) may be widely formed in a rectangular band shape to cover as much of the second surface (S2) of the unit pixel (PX) as possible, thereby minimizing leakage of light having penetrated the substrate 100 to the outside.

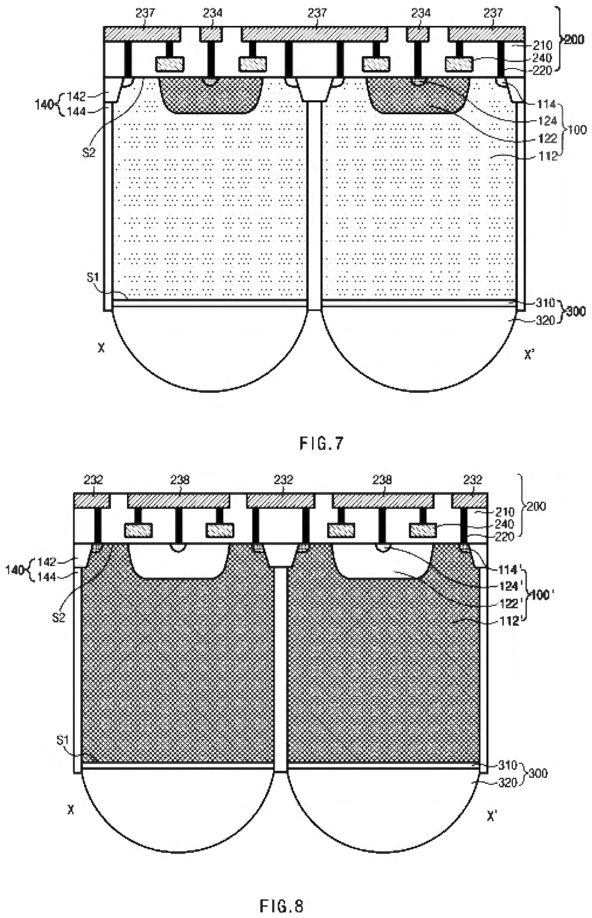

FIG. 7 is a cross-sectional view illustrating an example structure of an imaging device based on another embodiment of the disclosed technology.

Referring to FIG. 7, the metal interconnect connected to the field-dispersion electrode 240 may be formed as a single metal interconnect 237 connected to the metal interconnect connected to the first contact region 114. For example, the metal interconnect 237 may be formed in a shape in which the metal interconnects (232, 236a, 236b) of FIG. 4 are integrally connected to each other. Accordingly, the field-dispersion electrode 240 may be electrically connected to the P-type anode (e.g., the sensing node) through the metal interconnect 237.

In this way, the metal interconnect connected to the field-dispersion electrode 240 and the metal interconnect connected to the first contact region 114 commonly use the same metal interconnect 237, thereby reducing the number of metal interconnects compared to the structure of FIG. 4 described above.

FIG. 8 is a cross-sectional view illustrating an example structure of an image sensing device based on another embodiment of the disclosed technology.

Referring to FIG. 8, the unit pixel (PX) may include a first well region 112', a first contact region 114', a second well region 122', and a second contact region 124' formed within the substrate 100.

The first well region 112', the first contact region 114', the second well region 122', and the second contact region 124' of FIG. 8 differ from the first well region 112, the first contact region 114, the second well region 122, and the second contact region 124 of FIG. 4 in that the first well region 112', the first contact region 114', the second well region 122', and the second contact region 124' of FIG. 8 include impurities of another conductivity type opposite to those of the first well region 112, the first contact region 114, the second well region 122, and the second contact region 124 of FIG. 4.

For example, in FIG. 4, the first well region 112 and the first contact region 114 may include P-type impurities, while the second well region 122 and the second contact region 124 may include N-type impurities. In contrast, in FIG. 8, the first well region 112' and the first contact region 114' may include N-type impurities and the second well region 122' and the second contact region 124' may include P-type impurities.

The first contact region 114' may be a cathode, and may be a sensing node. The second contact region 124' may be an anode, and may be a biasing node. Therefore, the SPAD according to the embodiment of FIG. 8 may be an anode-biased SPAD in which a low reverse bias voltage is applied to the P-type impurity region (e.g., anode).

The formation positions and shapes of the first well region 112', the first contact region 114', the second well region 122', and the second contact region 124' of FIG. 8 may be the same as the formation positions and shapes of the first well region 112, the first contact region 114, the second well region 122, and the second contact region 124 of FIG. 4.

In the anode-biased SPAD, the metal interconnect connected to the field-dispersion electrode 240 may be formed as a single metal interconnect 238 connected to the metal interconnect connected to the second contact region 124'. For example, the metal interconnect 238 may be formed in a shape in which the metal interconnects (234, 236a, 236b) of FIG. 4 are integrally connected to each other. Accordingly, the field-dispersion electrode 240 may be electrically connected to the P-type anode (i.e., a biasing node) through the metal interconnect 238.

As described above, the metal interconnect connected to the field-dispersion electrode 240 and the metal interconnect connected to the second contact region 124' commonly use the same metal interconnect 238, thereby reducing the number of metal interconnects shown in FIG. 8 as compared to the structure of FIG. 4.

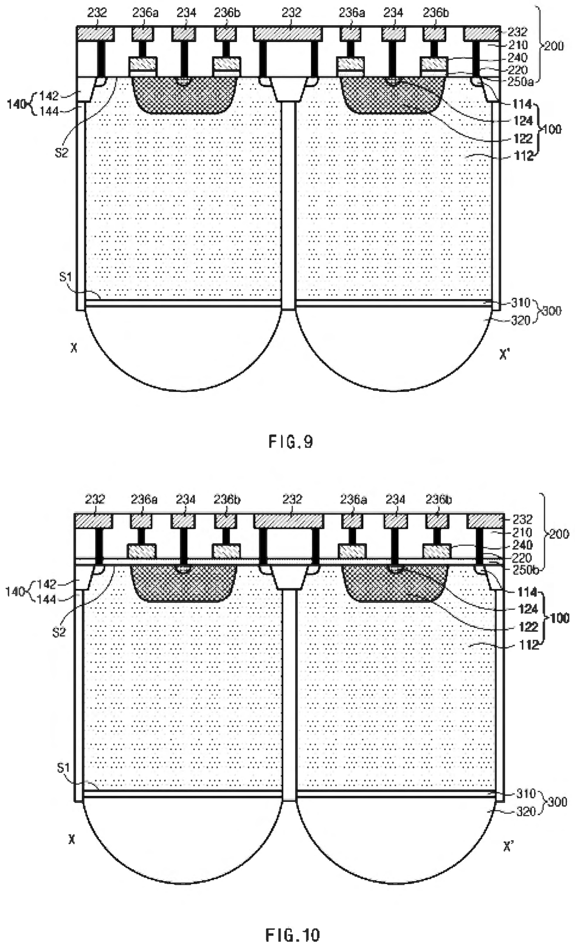

FIG. 9 is a cross-sectional view illustrating an example structure of an image sensing device based on another embodiment of the disclosed technology. FIG. 10 is a cross-sectional view illustrating an example structure of an image sensing device based on another embodiment of the disclosed technology.

Referring to FIGS. 9 and 10, the pixel array 14 may further include high-k (i.e., high permittivity) dielectric insulation layers (250a, 250b) disposed between the field-dispersion electrode 240 and the substrate 100. In some implementations, the term "high-k dielectric" can be used to indicate materials with a dielectric constant higher than SiO₂.

In some implementations, the high-k dielectric insulation layer 250a may be selectively located only below the field-dispersion electrode 240 with the same size and shape as the field-dispersion electrode 240, as shown in FIG. 9. Alternatively, the high-k dielectric insulation layer 250b may be located to entirely cover the first well region 112 and the second well region 122, as shown in FIG. 10.

In this way, the high-k dielectric insulation layers (250a, 250b) formed between the field-dispersion electrode 240 and the substrate 100 may better generate a depletion phenomenon in the edge region of the P-N junction, thereby increasing the effects of electric field dispersion.

As discussed above, the image sensing device based on some embodiments of the disclosed technology may include avalanche breakdown to occur in a wide and uniform region, thereby improving the pixel sensitivity of the image sensing device.

The embodiments of the disclosed technology may provide a variety of effects capable of being directly or indirectly recognized through the above-mentioned patent document.

Although a number of illustrative embodiments have been described, it should be understood that various modifications or enhancements of the disclosed embodiments and other embodiments can be devised based on what is described and/or illustrated in this patent document.

## Claims

1. An image sensing device comprising:
a substrate including a first surface and a second surface opposite to the first surface;
a first well region including impurities of a first conductivity type and disposed in the substrate to be in contact with the second surface;
a second well region including impurities of a second conductivity type opposite to the first conductivity type and disposed in the substrate to be in contact with the first well region;
a plurality of interconnects configured to provide electrical connections within the image sensing device;
a plurality of contact plugs configured to provide electrical connections to the plurality of interconnects,
wherein the plurality of interconnects includes first, second, and third interconnects, and the plurality of contact plugs includes first, second, and third contact plugs,
wherein the first interconnect is electrically connected to the first well region through the first contact plug, and the second interconnect is electrically connected to the second well region through the second contact plug; and
a field-dispersion electrode connected to the third interconnect through the third contact plug and disposed to cover an edge region of the second well region between the first contact plug and the second contact plug.

2. The image sensing device according to claim 1, wherein the field-dispersion electrode is configured to:
cover an edge region of a junction between the first well region and the second well region.

3. The image sensing device according to claim 1, wherein:
the field-dispersion electrode has a band shape and covers the edge region of the second well region.

4. The image sensing device according to claim 2, wherein:
the third interconnect has an island shape and overlaps the field-dispersion electrode.

5. The image sensing device according to claim 2, wherein:
the third interconnect has a band shape and overlaps the field-dispersion electrode.

6. The image sensing device according to claim 1, wherein the first interconnect is configured to:
cover an edge region of the first well region, such that the field-dispersion electrode remains entirely exposed.

7. The image sensing device according to claim 1, wherein:
the third interconnect is connected to the first interconnect.

8. The image sensing device according to claim 1, wherein:
the third interconnect is connected to the second interconnect.

9. The image sensing device according to claim 1, wherein:
the second well region is configured to extend in a depth direction from the second surface such that both a side surface and a bottom surface of the second well region are in contact with the first well region.

10. The image sensing device according to claim 1, further comprising:
a high-k dielectric insulation layer disposed between the field-dispersion electrode and the substrate.

11. The image sensing device according to claim 10, wherein:
the high-k dielectric insulation layer is selectively disposed only below the field-dispersion electrode.

12. The image sensing device according to claim 10, wherein:
the high-k dielectric insulation layer is disposed to entirely cover the first well region and the second well region.

13. The image sensing device according to claim 1, further comprising:
a first contact region disposed in the first well region to contact the first contact plug and including the first-conductivity-type impurities at a higher concentration than the first well region; and
a second contact region disposed in the second well region to contact the second contact plug and including the second- conductivity-type impurities at a higher concentration than the second well region.

14. The image sensing device according to claim 13, wherein:
the first contact region is disposed in an edge region of the first well region and has a band shape surrounding the second well region.
